# EUROPÄISCHE PATENTSCHRIFT

(11) **EP 0 445 624 B1**
(45) Veröffentlichungstag und Bekanntmachung des Hinweises auf die Patenterteilung: **09.04.1997**
(21) Anmeldenummer: 91102779.5
(22) Anmeldetag: 26.02.1991
(51) Int. Cl.: G03F 7/032

(54) **Photopolymerisierbares Gemisch und daraus hergestelltes Aufzeichnungsmaterial**
Photopolymerisable composition and recording material produced therefrom
Composition photopolymérisable et matériau d'enregistrement produit de cela

(30) Priorität: 09.03.1990 DE 4007428
(43) Veröffentlichungstag der Anmeldung: 11.09.1991
(73) Patentinhaber: Agfa-Gevaert AG, D-51373 Leverkusen (DE)
(72) Erfinder: Zertani, Rudolf, Dr., W-6500 Mainz 43 (DE); Mohr, Dieter, Dr., W-6501 Budenheim (DE)

(56) Entgegenhaltungen:
- EP-A- 0 256 981
- EP-A- 0 364 735
- EP-B- 0 119 162
- EP-B- 0 122 223
- DE-A- 3 839 394

## Beschreibung

Die Erfindung betrifft ein photopolymerisierbares Gemisch, das ein polymeres Bindemittel, eine polymerisierbare Verbindung, insbesondere einen Acryl- oder Alkacrylsäureester, sowie eine Photoinitiatorkombination enthält.

Photopolymerisierbare Gemische, die zur Erhöhung der Lichtempfindlichkeit bestimmte Kombinationen von Photoinitiatoren und Aktivatoren, z.B. von Carbonylgruppen enthaltenden Initiatoren und tertiären Aminen, enthalten, sind bekannt. Derartige synergistisch wirkende Gemische sind z.B. in den US-A 3 759 807, 4 054 682 und 4 071 424 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129214, angemeldet am 02.04.1974 unter der Nummer 49/36614, wird ein photopolymerisierbares Gemisch beschrieben, das als polymerisierbare Verbindung einen Tetra(meth)acrylsäureester eines N,N,N',N'-Tetrahydroxyalkyl-alkylendiamins enthält. Die tetrafunktionelle Verbindung dient als Vernetzungsmittel.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und tionsmitteln, z.B. Aminen, anstoßen kann (US-A 3097096). Diese Initiatorkombinationen werden jedoch im wesentlichen nur in wäßriger Lösung oder in Kombination mit wasserlöslichen Bindemitteln eingesetzt. Initiatorkombinationen aus photoreduzierbaren Farbstoffen und anderen Reduktionsmitteln sind in den US-A 3 597 343 und 3 488 269 beschrieben.

Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

In der JP-A 54/151024 ist ein photopolymerisierbares Gemisch beschrieben, das eine Initiatorkombination aus einem Merocyaninfarbstoff und einem methylsubstituierten s-Triazin enthält und gegenüber sichtbarem Licht, z.B. einem Argonlaser, empfindlich ist. Die Empfindlichkeit dieser Gemische gegenüber sichtbarem Laserlicht ist jedoch für eine wirtschaftliche Nutzung nicht ausreichend.

In der EP-A 287 817 werden photopolymerisierbare Gemische beschrieben, die (Meth)acrylsäureester mit Urethangruppen, tertiären Aminogruppen und ggf. Harnstoffgruppen im Molekül, polymere Bindemittel und, als Photoinitiatoren, eine Kombination aus einem photoreduzierbaren Farbstoff, einer strahlungsempfindlichen Trihalogenmethylverbindung und einer Acridin-, Phenazin- oder Chinoxalinverbindung enthalten.

In der EP-A 321 826 werden ähnliche Gemische mit (Meth)acrylsäureestern beschrieben, die keine Urethangruppen enthalten.

In der US-A 3 717 558 sind Metallocene von Elementen der Nebengruppen IIa bis VIIIa in Kombination mit einem weiteren Photoinitiator mit einer Carbonsäurechloridgruppe für den Einsatz in photopolymerisierbaren Aufzeichnungsmaterialien beschrieben. Diese Initiatorkombinationen sind sehr sauerstoff- und hydrolyseempfindlich und dadurch für die Herstellung von Druckplatten und Resistmaterialien weniger geeignet. Weitere Metallocene und deren Einsatz als Photoinitiatoren in photopolymerisierbaren Gemischen werden in den EP-A 119 162 und 122 223 beschrieben. Hierbei handelt es sich um Titanocene mit guter Stabilität gegen Luft, die eine spektrale Empfindlichkeit im Bereich vom UV-Licht bis zum sichtbaren Licht aufweisen. Sie enthalten als Liganden unter anderem Cyclopentadienylreste und fluorierte Phenylreste. Ferner werden in den EP-A 242 330 und 269 573 photopolymerisierbare Gemische beschrieben, die eine Photoinitiatormischung, bestehend aus einem Titanocen und einem flüssigen Photoinitiator vom Typ eines Hydroxy- oder Aminoacetophenons enthalten. Bei diesen Materialien ist die erzielbare Lichtempfindlichkeit für eine schnelle Bebilderung mit einem energieschwachen und zugleich kostengünstigen Argonionenlaser nicht ausreichend.

In der nicht vorveröffentlichten älteren europäischen Patentanmeldung EP-A-0 364 735 werden photopolymerisierbare Gemische beschrieben, die
- ein polymeres Bindemittel,
- eine radikalisch polymerisierbare Verbindung mit mindestens einer polymerisierbaren Gruppe,
- einen photoreduzierbaren Farbstoff,
- eine durch Strahlung spaltbare methylverbindung und
- eine Metallocenverbindung, insbesondere ein Titanocen oder Zirkonocen,
enthalten. Als Metallocene werden solche eingesetzt, die als Liganden zwei ggf. substituierte Cyclopentadienylreste und zwei substituierte Phenylreste tragen. Die Phenylreste tragen in o-Stellung zur Bindung mindestens ein Fluoratom und enthalten ggf. weitere Substituenten, wie Cl, Br, Alkyl- oder Alkoxygruppen; bevorzugt und in den Beispielen beschrieben werden Verbindungen mit fluorphenylresten. Diese Gemische weisen eine außerordentlich hohe Lichtempfindlichkeit auf. Ihre Lagerfähigkeit, insbesondere bei erhöhten Temperaturen, ist aber begrenzt.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich, sowie durch eine gute thermische Lagerstabilität auszeichnen und die insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile
a) ein polymeres Bindemittel,
b) eine radikalisch polymerisierbare Verbindung mit mindestens einer polymerisierbaren Gruppe,
c) einen photoreduzierbaren Farbstoff
enthält.

Das erfindungsgemäße Gemisch ist dadurch gekennzeichnet, daß es ferner
d) ein Dicyclopentadienyl-bis-2,4,6-trifluorphenyl-titan oder -zirkon
enthält.

Die als Initiatorbestandteil eingesetzten Metallocene sind als solche und auch als Photoinitiatoren bekannt, z.B. aus der US-A 4 590 287. Bevorzugt werden die Verbindungen des Titans. Derartige Verbindungen sind z. B. in den EP-A 119 162 und 122 223 beschrieben.

Die Cyclopentadienylgruppen können insbesondere durch Alkylreste mit 1 bis 4 Kohlenstoffatomen, Chloratome, Phenyl- oder Cyclohexylreste substituiert oder durch Alkylengruppen miteinander verknüpft sein. Die Cyclopentadienylgruppen sind bevorzugt entweder unsubstituiert oder durch Alkylreste oder Chloratome substituiert. Der Mengenanteil an Metallocenverbindung liegt im allgemeinen zwischen 0,01 und 10, vorzugsweise bei 0,05 bis 6 Gew.-%, bezogen auf die nichtflüchtigen Anteile des Gemischs.

Das erfindungsgemäße Gemisch enthält als weiteren Photoinitiatorbestandteil einen photoreduzierbaren Farbstoff. Geeignete Farbstoffe sind insbesondere Xanthen-, Benzoxanthen-, Benzothioxanthen-, Thiazin-, Pyronin, Porphyrin- oder Acridinfarbstoffe.

Geeignete Xanthen- und Thiazinfarbstoffe sind z.B. in der EP-A 287 817 beschrieben. Geeignete Benzoxanthen- und Benzothioxanthenfarbstoffe sind in der DE-A 20 25 291 und der EP-A 321 828 beschrieben.

Als Porphyrinfarbstoff ist z.B. Hämatoporphyrin und als Acridinfarbstoff z.B. Acriflaviniumchlorid-Hydrochlorid geeignet.

Beispiele für Xanthenfarbstoffe sind Eosin B (C.I. Nr. 45400), Eosin J (C.I. Nr. 45380), Eosin alkohollöslich (C.I. 45386), Cyanosin (C.I. Nr.45410), Bengalrosa, Erythrosin (C.I. Nr. 45430), 2,3,7-Trihydroxy-9-phenyl-xanthen-6-on und Rhodamin 6 G (C.I. Nr. 45160).

Beispiele für Thiazinfarbstoffe sind Thionin (C.I. Nr. 52000), Azur A (C.I. Nr. 52005) und Azur C (C.I. Nr.52002).

Beispiele für Pyroninfarbstoffe sind Pyronin B (C.I. Nr. 45010) und Pyronin GY (C.I. Nr. 45005). Die Menge des photoreduzierbaren Farbstoffs liegt im allgemeinen zwischen 0,01 und 10, vorzugsweise zwischen 0,05 und 4 Gew.-%, bezogen auf die nichtflüchtigen Anteile des Gemischs.

Zur Steigerung der Lichtempfindlichkeit enthalten die erfindungsgemäßen Gemische vorzugsweise noch Verbindungen mit photolytisch spaltbaren Trihalogenmethylgruppen, die als radikalbildende Photoinitiatoren für photopolymerisierbare Gemische an sich bekannt sind. Als derartige Coinitiatoren haben sich besonders Verbindungen mit Chlor und Brom, insbesonder Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137452, der DE-A 2718259 und der DE-A 2243621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z.B. Phenyltrihalogenmethylsulfone oder Phenyltrihalogenmethylketone, z.B. das Phenyltribrommethylsulfon, sind geeignet.

Diese Halogenverbindungen werden im allgemeinen in einer Menge von 0,01 bis 10, vorzugsweise von 0,05 bis 4 Gew.-%, bezogen auf die nichtflüchtigen Bestandteile des Gemischs, eingesetzt.

Die erfindungsgemäßen Gemische enthalten ggf. als weiteren Initiatorbestandteil eine Acridin-, Phenazin- oder Chinoxalinverbindung. Diese Verbindungen sind als Photoinitiatoren bekannt und in den DE-C 2027467 und 2039861 beschrieben. Durch diese Verbindungen wird die Empfindlichkeit des Gemischs vor allem im nahen Ultraviolettbereich gesteigert. Geeignete Vertreter dieser Verbindungsklasse sind in den genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet. Als Chinoxalinderivate kommen insbesondere die 2,3-Diphenylderivate in Betracht, die vorzugsweise in den beiden Phenylresten durch Methoxygruppen weiter substituiert sind. Im allgemeinen werden die Acridinderivate bevorzugt. Die Menge dieser Komponente im Gemisch liegt im Bereich von 0 bis 10 Gew.-%, vorzugsweise zwischen 0,05 und 5 Gew.-%. Wenn eine weitere Empfindlichkeitssteigerung des Gemischs im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4'-disubstituierte Dibenzalacetone, z.B. Diethylamino-4'-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge dieser Verbindung liegt im Bereich von 0 bis 10, vorzugsweise von 0,05 bis 4 Gew.-%, bezogen auf die nichtflüchtigen Bestandteile des Gemischs. Die Gesamtmenge an Polymerisationsinitiatoren liegt im allgemeinen bei 0,05 bis 20, vorzugsweise bei 0,1 bis 10 Gew.-%.

Für die Zwecke der Erfindung geeignete polymerisierbare Verbindungen sind bekannt und z.B. in den US-A 2760863 und 3060023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Besonders bevorzugt werden polymerisierbare Verbindungen, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile heterocyclischer Ringe sein können, Enolgruppen und Carboxylgruppen in Kombination mit olefinischen Doppelbindungen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel I 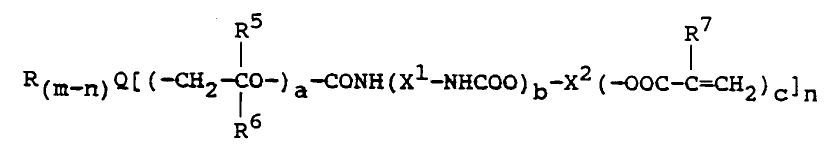 worin 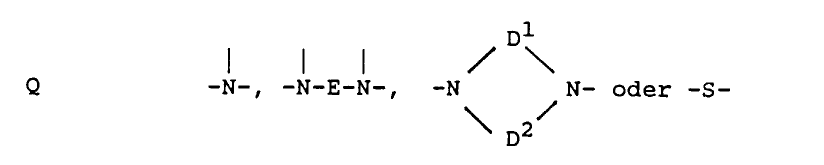
- R: eine Alkyl-, Hydroxyalkyl- oder Arylgruppe,
- R⁵ und R⁶: jeweils ein Wasserstoffatom, eine Alkylgruppe oder Alkoxyalkylgruppe,
- R⁷: ein Wasserstoffatom, eine Methyl- oder Ethylgruppe,
- X¹: eine gesättigte Kohlenwasserstoffgruppe mit 2 bis 12 Kohlenstoffatomen,
- X²: eine (c+1)-wertige gesättigte Kohlenwasserstoffgruppe,in der bis zu 5 Methylengruppendurch Sauerstoffatome ersetzt sein können,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,
- a: 0 oder eine Zahl von 1 bis 4,
- b: 0 oder 1,
- c: eine ganze Zahl von 1 bis 3,
- m: je nach Wertigkeit von Q 2, 3 oder 4 und
- n: eine ganze Zahl von 1 bis m
bedeutet, wobei alle Symbole gleicher Definition untereinander gleich oder verschieden sein können. Die Verbindungen dieser Formel, ihre Herstellung und Verwendung sind ausführlich in der EP-A 287 818 beschrieben. Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d.h. in denen m = n ist, werden im allgemeinen bevorzugt. Im allgemeinen ist in nicht mehr als einem, bevorzugt in keinem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn R⁵ und R⁶ Alkyl- oder Alkoxyalkylgruppen sind, können diese 1 bis 5 Kohlenstoffatome enthalten. R⁷ ist bevorzugt ein Wasserstoffatom oder eine Methylgruppe, insbesondere eine Methylgruppe.

X¹ ist bevorzugt ein geradkettiger oder verzweigter aliphatischer oder cycloaliphatischer Rest mit vorzugsweise 4 bis 10 Kohlenstoffatomen. X² hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. X² kann auch eine cycloaliphatische Gruppe mit 5 bis 10 Kohlenstoffatomen, insbesondere eine Cyclohexylengruppe sein. D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt. Der Wert von c ist vorzugsweise 1.

Weitere geeignete Verbindungen mit photooxydierbaren Gruppen sind Verbindungen der Formel II 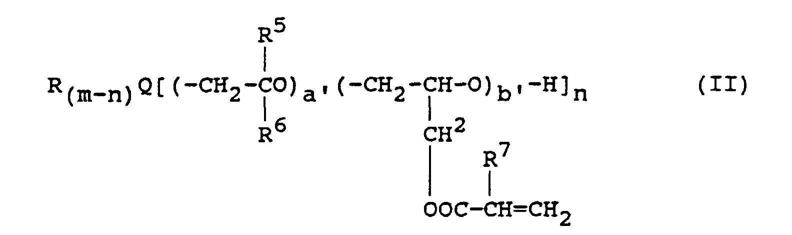 worin Q, R, R⁵, R⁶, R⁷, m und n die oben angegebene Bedeutung haben und Q zusätzlich eine Gruppe 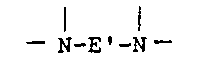 sein kann, worin E' eine Gruppe der Formel III 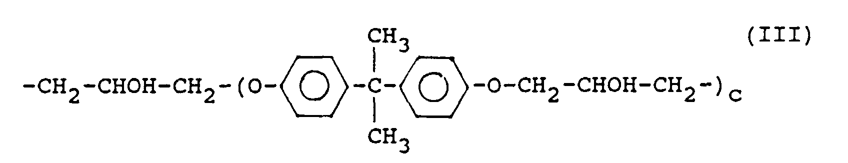 ist, in der c die Bedeutung wie in Formel I hat; a' und b' sind ganze Zahlen von 1 bis 4.

Die Verbindungen dieser Formel, ihre Herstellung und Verwendung sind ausführlich in der EP-A 316 706 beschrieben.

Weitere geeignete Verbindungen mit photooxydierbaren Gruppen sind Acryl- und Alkacrylsäureester der Formel IV 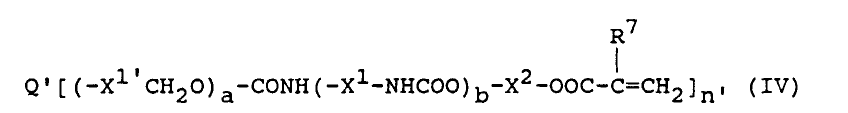 worin 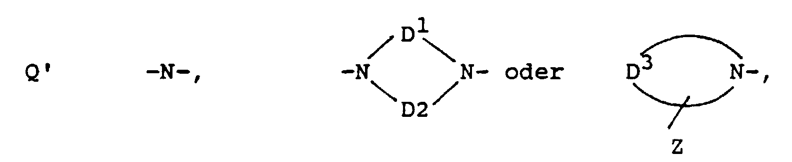
- X¹': CᵢH₂ᵢ oder 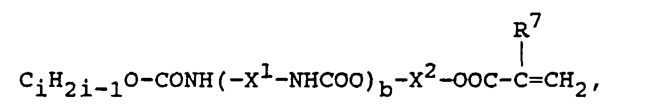
- D³: eine gesättigte Kohlenwasserstoffgruppe mit 4 bis 8 Kohlenstoffatomen, die mit dem Stickstoffatom einen 5- oder 6-gliedrigen Ring bildet,
- Z: ein Wasserstoffatom oder einen Rest der Formel 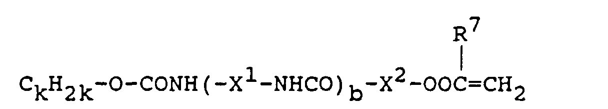
- i und k: ganze Zahlen von 1 bis 12,
- n': je nach Wertigkeit von Q' 1, 2 oder 3
bedeutet, und R⁷, X¹, X², D¹, D², a und b die bei Formel I angegebene Bedeutung haben, wobei alle Symbole gleicher Definition untereinander gleich oder verschieden sein können und wobei in mindestens einem Substituenten an der Gruppe Q a = O ist.

Von den Verbindungen der Formel IV werden solche bevorzugt, die außer einer Harnstoffgruppe mindestens eine Urethangruppe enthalten. Als Harnstoffgruppen sollen Gruppen der Formel

〉N - CO - N〈

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel IV vorzugsweise 0 oder 1; i ist vorzugsweise eine Zahl von 2 bis 10.

Die polymerisierbaren Verbindungen der Formel IV werden analog zu den Verbindungen der Formel I hergestellt. Die Verbindungen der Formel IV und ihre Herstellung sind ausführlich in der EP-A 355 387 beschrieben.

Der Mengenanteil der photopolymerisierbaren Schicht an polymerisierbaren Verbindungen beträgt im allgemeinen etwa 10 bis 80, bevorzugt 20 bis 60 Gew.-%, bezogen auf die nichtflüchtigen Bestandteile.

Beispiele für verwendbare Bindemittel sind chloriertes Polyethylen, chloriertes Polypropylen, Poly(meth)acrylsäurealkylester, bei denen die Alkylgruppe z.B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z.B. Nylon-6), Polyurethane, Methylcellulose, Ethylcellulose, Acetylcellulose, Polyvinylformal und vinylbutyral.

Besonders geeignet sind Bindemittel, die in Wasser unlöslich, in organischen Lösemitteln löslich und in wässrig alkalischen Lösungen löslich oder zumindest quellbar sind.

Besonders erwähnt werden sollen Carboxylgruppen enthaltende Bindemittel, z.B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin geeignet sind Umsetzungsprodukte aus Polymeren, die H-acide Gruppen tragen, welche ganz oder teilweise mit aktivierten Isocyanaten umgesetzt wurden, wie beispielsweise Umsetzungsprodukte aus xylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200000 oder darüber, bevorzugt 1000 bis 100000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:
Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z.B. Novolake. Die Menge des Bindemittels in der lichtempfindlichen Schicht beträgt im allgemeinen 20 bis 90, vorzugsweise 40 bis 80 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 300 nm bis 700 nm und umspannt damit einen sehr breiten Bereich. Durch die Kombination von photoreduzierbaren Farbstoffen mit photolytisch spaltbaren Halogenverbindungen und Metallocenen wird ein synergistisch wirkendes Initiatorsystem erhalten, dessen Aktivität, besonders im langwelligen Spektralbereich bei oder oberhalb 455 nm, in photopolymerisierbaren Gemischen den bekannten Photoinitiatorkombinationen überlegen ist. Durch die erfindungsgemäß eingesetzten speziellen Metallocene, insbesondere von Dicyclopentadienyl-bis-2,4,6-trifluorphenyl-titan, ergibt sich neben einer sehr hohen Lichtempfindlichkeit überraschenderweise eine sehr gute thermische Stabilität der Schichten.

Besonders hohe Lichtempfindlichkeiten werden in Kombination mit polymerisierbaren Verbindungen erhalten, die photooxydierbare Gruppen enthalten. Durch den Ersatz von Acridin-, Phenazin- oder Chinoxalinverbindungen, die als Coinitiatoren in sonst gleichen photopolymerisierbaren Gemischen, wie sie z. B. in der EP-A 287 817 beschrieben sind, durch die oben beschriebenen Metallocenverbindungen oder durch zusätzliche Verwendung der Metallocene neben den genannten Mehrkernheterocyclen werden Gemische mit wesentlich höherer Lichtempfindlichkeit erhalten. Auch gegenüber Gemischen mit bekannten, Metallocene enthaltenden Initiatorkombinationen zeigen die erfindungsgemäßen Gemische eine erheblich höhere Lichtempfindlichkeit.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z.B. Herstellung von Texten in Blindenschrift, von Einzelkopien, Gerbbildern, Pigmentbildern usw. Weiter sind die Gemische zur photomechanischen Herstellung von Ätzreservagen, z. B. für die Fertigung von Namensschildern, von kopierten Schaltungen und für das Formteilätzen, anwendbar.

Besondere Bedeutung haben die erfindungsgemäßen Gemische als Aufzeichnungsschichten für die Herstellung von Flachdruckplatten und für die Photoresisttechnik. Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Durch die breite spektrale Empfindlichkeit des erfindungsgemäßen Aufzeichnungsmaterials können alle dem Fachmann geläufigen Lichtquellen verwendet werden, z.B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das lichten in üblichen Projektions- und Vergrößerungsgeräten unter dem Licht der Metallfadenlampe und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z.B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt.

Hierfür geeignete Materialien sind z. B. Polyvinylalkohol, Polyphosphate, Zucker usw. Solche Deckschichten haben im allgemeinen eine Dicke von 0,1 bis 10, vorzugsweise 1 bis 5 µm. Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiele 1-6 (Vergleichsbeispiele)

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung der folgenden Zusammensetzung überzogen. Dabei wurden alle Operationen unter Rotlicht durchgeführt:

| | |
|---|---|
| 2,84 Gt | einer 22,3 %igen Lösung eines Terpolymerisats aus Styrol, n-Hexylmethacrylat und Methacrylsäure (10:60:30) mit der Säurezahl 190 in Methylethylketon, |
| 1,49 Gt | Monomeres gemäß Tabelle 1, |
| 0,04 Gt | Eosin alkohollöslich (C.I. 45386), |
| 0,03 Gt | 2,4-Bis-trichlormethyl-6-(4-styrylphenyl)-s-triazin und |
| 0,01 Gt | Dicyclopentadienyl-bis-pentafluorphenyl-titan in |
| 22 Gt | Propylenglykolmonomethylether. |

Das Auftragen erfolgte durch Aufschleudern in der Weise, daß ein Trockengewicht von 2,4 bis 2,8 g/m² erhalten wurde. Anschließend wurde die Platte zwei Minuten bei 100 °C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 2,5 bis 4 g/m² erhalten. Die erhaltene Druckplatte wurde mittels einer 2 kW-Metallhalogenidlampe im Abstand von 110 cm unter einem 13-stufigen Belichtungskeil mit Dichteinkrementen von 0,15 belichtet. Um die Empfindlichkeit der Druckplatten im sichtbaren Licht zu testen, wurden auf den Belichtungskeil ein 3 mm starkes Kantenfilter der Firma Schott mit der Kantendurchlässigkeit von 455 nm und ein Silberfilm mit gleichmäßiger Schwärzung (Dichte 1,4) und gleichmäßiger Absorption über den wirksamen Spektralbereich als Graufilter montiert. Die Platten wurden 20 Sekunden belichtet, und danach eine Minute auf 100 °C erwärmt. Anschließend wurden sie mit einem Entwickler folgender Zusammensetzung entwickelt:

| | |
|---|---|
| 120 Gt | Natriummetasilikat x 9 H₂O, |
| 2,13 Gt | Strontiumchlorid, |
| 1,2 Gt | nichtionogenes Netzmittel (Kokosfettalkohol-Polyoxyethylenether mit ca. 8 Oxyethyleneinheiten) und |
| 0,12 Gt | Antischaummittel in |
| 4000 Gt | vollentsalztem Wasser. |

Die Platten wurden mit fetter Druckfarbe eingefärbt. Es wurden die in Tabelle 2 angegebenen vollvernetzten Keilstufen erhalten.

**Tabelle 1**

| Beispiel Nr. | Monomeres |
|---|---|
| 1 | Umsetzungsprodukt von 1 mol Triethanolamin mit 3 mol Isocyanatoethylmethacrylat, |
| 2 | Umsetzungsprodukt von 1 mol N,N'-Bis-β-hydroxyethyl-piperidin mit 2 mol Isocyanatoethylmethacrylat, |
| 3 | Umsetzungsprodukt von 1 mol Triethanolamin mit 3 mol Glycidylmethacrylat, |
| 4 | Umsetzungsprodukt von 1 mol 2,2,4-Trimethyl-hexamethylendiisocyanat mit 2 mol 2-Hydroxy-ethylmethacrylat, |
| 5 | Umsetzungsprodukt von 1 mol Hexamethylendiisocyanat mit 1 mol 2-Hydroxy-ethylmethacrylat und 0,33 mol Triethanolamin, |
| 6 | Trimethylolethantriacrylat |

**Tabelle 2**

| Beispiel Nr. | Graufilter | Keilstufen |
|---|---|---|
| 1 | ja | 8 - 9 |
| 2 | ja | 9 |
| 3 | ja | 7 - 9 |
| 4 | ja | 6 - 7 |
| 5 | ja | 7 - 9 |
| 6 | ja | -* |
| 6 | nein | 3 - 4 |

| | | |
|---|---|---|
| * Kein Bild | | |

### Beispiele 7-12

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,5 g/m² erhalten wurde:

| | |
|---|---|
| 2,84 Gt | der in Beispiel 1 angegebenen Terpolymerisatlösung, |
| 1,49 Gt | Monomeres gemäß Tabelle 1, |
| 0,04 Gt | Eosin alkohollöslich (C.I. 45386), |
| 0,03 Gt | 2,4-Bis-trichlormethyl-6-(4-styrylphenyl)-s-triazin und |
| 0,01 Gt | Dicyclopentadienyl-bis-2,4,6-trifluorphenyl-titan |
| 22 Gt | Propylenglykolmonomethylether. |

Nach Auftragen einer Deckschicht aus Polyvinylalkohol wurden die Platten in gleicher Weise wie in Beispiel 1 20 Sekunden belichtet und dann entwickelt. Um die Empfindlichkeit der Druckplatten im sichtbaren Licht zu testen, wurden auf den Belichtungskeil ein 3 mm starkes Kantenfilter der Firma Schott mit der Kantendurchlässigkeit von 455 nm und - soweit angegeben - ein Silberfilm mit gleichmäßiger Schwärzung (Dichte 1,1) als Graufilter montiert. Es wurden die in Tabelle 3 angeführten vollvernetzten Keilstufen erhalten:

**Tabelle 3**

| Beispiel Nr | Monomeres aus Beispiel | Graufilter | Keilstufen |
|---|---|---|---|
| 7 | 1 | ja | 9 -10 |
| 8 | 2 | ja | 9 |
| 9 | 3 | ja | 10 -11 |
| 10 | 4 | ja | 7 - 8 |
| 11 | 5 | ja | 8 |
| 12 | 6 | ja | -* |
| 12 | 6 | nein | 3 - 5 |

| | | | |
|---|---|---|---|
| * Kein Bild | | | |

Mit den Druckplatten aus den Beispielen 1 -12 wurde ein Lagertest bei 80 °C über den Zeitraum von 4 Stunden in einem Umlufttrockenschrank durchgeführt. Die Belichtung und Entwicklung wurden nach 4 Stunden wie oben angegeben durchgeführt.

Folgendes Ergebnis wurde gefunden: Beispiele 1-6 ergaben kein Bild auf dem Aluminiumträger. Für die Beispiele 7-12 wurden die in der Tabelle 4 angeführten vollvernetzten Keilstufen gefunden.

**Tabelle 4**

| Beispiel Nr. | Monomer Nr. | Graufilter | Keilstufen |
|---|---|---|---|
| 7 | 1 | ja | 7 - 8 |
| 8 | 2 | ja | 8 |
| 9 | 3 | ja | 9 -10 |
| 10 | 4 | ja | 5 - 6 |
| 11 | 5 | ja | 6 |
| 12 | 6 | ja | -* |
| 12 | 6 | nein | 1 - 3 |

| | | | |
|---|---|---|---|
| * Kein Bild | | | |

Die bei 80 °C gelagerten Druckplatten ergaben auch nach 4 Stunden Lagerzeit über 100.000 einwandfreie Drucke.

### Beispiel 13

Die Beschichtungslösung aus Beispiel 7 wurde auf eine biaxial verstreckte 35 µm dicke Polyethylenterephthalatfolie so aufgeschleudert, daß nach dem Trocknen ein Schichtgewicht von 15 g/m² erhalten wurde. Die Schicht wurde drei Minuten bei 100 °C im Umlufttrockenschrank nachgetrocknet. Anschließend wurde die Schicht bei 115 °C mit 1,5 m/min auf einen gereinigten Träger laminiert, der aus einer Isolierstoffplatte mit 35 µm Kupferauflage bestand.

Die Schicht wurde mittels einer 2 kW-Metallhalogenidlampe (140 cm Abstand) unter einem Kantenfilter 455 nm, wie im Beispiel 1 beschrieben, mit einem Stufenkeil als Vorlage 30 Sekunden belichtet und nach dem Abziehen der Folie mit 0,8 %iger Sodalösung in einem Sprühprozessor 20 Sekunden entwickelt. Es wurden 6 vollvernetzte Keilstufen erhalten. Die vernetzte Schicht war gegen die in der Leiterplattentechnik übliche Eisen-III-chlorid-Lösung resistent. Die festigkeit war gut.

## Patentansprüche

1. Photopolymerisierbares Gemisch, das als wesentliche Bestandteile
a) ein polymeres Bindemittel
b) eine radikalisch polymerisierbare Verbindung mit mindestens einer polymerisierbaren Gruppe und
c) einen photoreduzierbaren Farbstoff
enthält, dadurch gekennzeichnet, daß es ferner
d) ein Dicyclopentadienyl-bis-2,4,6-trifluorphenyl-titan oder -zirkon enthält.

2. Gemisch nach Anspruch 1, dadurch gekennzeichnet, daß es zusätzlich
e) eine durch Strahlung spaltbare methylverbindung
enthält.

3. Gemisch nach Anspruch 1, dadurch gekennzeichnet daß mindestens einer der Cyclopentadienylreste substituiert ist.

4. Gemisch nach Anspruch 1, dadurch gekennzeichnet, daß die radikalisch polymerisierbare Verbindung ein Acryl- oder Alkacrylsäureester mit mindestens einer bei Belichtung in Gegenwart des photoreduzierbaren Farbstoffs photooxydierbaren Gruppe ist.

5. Gemisch nach Anspruch 4, dadurch gekennzeichnet, daß die photooxydierbare Gruppe eine Amino-, Harnstoff-, Thio- oder Enolgruppe ist.

6. Gemisch nach Anspruch 1, dadurch gekennzeichnet, daß der photoreduzierbare Farbstoff ein Xanthen-, Thiazin-, Pyronin-, Porphyrin- oder Acridinfarbstoff ist.

7. Gemisch nach Anspruch 2, dadurch gekennzeichnet, daß die durch Strahlung spaltbare Trihalogenmethylverbindung ein s-Triazin, das durch mindestens eine Trihalogenmethylgruppe und ggf. eine weitere Gruppe substituiert ist, oder ein Aryltrihalogenmethylsulfon ist.

8. Gemisch nach Anspruch 1, dadurch gekennzeichnet, daß es als Photoinitiator ferner eine als Photoinitiator wirksame Acridin-, Phenazin- oder Chinoxalinverbindung enthält.

9. Gemisch nach Anspruch 1, dadurch gekennzeichnet, daß das Bindemittel wasserunlöslich und in wäßrig-alkalischen Lösungen löslich ist.

10. Gemisch nach Anspruch 1, dadurch gekennzeichnet, daß es 10 bis 80 Gew.-% polymerisierbare Verbindung, 20 bis 90 Gew.-% polymeres Bindemittel und 0,05 bis 20 Gew.-%, bezogen auf die nichtflüchtigen Bestandteile des Gemischs, an strahlungsaktivierbaren Polymerisationsinitiatoren enthält.

11. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

12. Aufzeichnungsmaterial nach Anspruch 11, dadurch gekennzeichnet, daß es auf der photopolymerisierbaren Schicht eine weitere, transparente, für Luftsauerstoff wenig durchlässige Schicht enthält, die in einer Entwicklerflüssigkeit für die photopolymerisierbare Schicht löslich ist.

## Claims

1. Photopolymerisable mixture which contains as essential constituents
a) a polymeric binder
b) a free-radically polymerisable compound having at least one polymerisable group and
c) a photo-reducible dye,
characterised in that it furthermore contains
d) a dicyclopentadienyl-bis-2,4,6-trifluorophenyl titanium or dicyclopentadienyl-bis-2,4,6-trifluorophenyl zirconium.

2. Mixture according to claim 1, characterised in that it additionally contains
e) a radiation-cleavable trihalomethyl compound.

3. Mixture according to claim 1, characterised in that at least one of the cyclopentadienyl residues is substituted.

4. Mixture according to claim 1, characterised in that the free-radically polymerisable compound is an acrylic or alkacrylic acid ester having at least one group which is photo-oxidisable on exposure in the presence of the photo-reducible dye.

5. Mixture according to claim 4, characterised in that the photo-oxidisable group is an amino, urea, thio or enol group.

6. Mixture according to claim 1, characterised in that the photo-reducible dye is a xanthene, thiazine, pyronine, porphyrin or acridine dye.

7. Mixture according to claim 2, characterised in that the radiation-cleavable trihalomethyl compound is an s-triazine, which is substituted by at least one trihalomethyl group and optionally one further group, or an aryltrihalomethylsulphone.

8. Mixture according to claim 1, characterised in that it furthermore contains as photoinitiator a acridine, phenazine or quinoxaline compound which is effective as a photoinitiator.

9. Mixture according to claim 1, characterised in that the binder is insoluble in water and soluble in aqueous/alkaline solutions.

10. Mixture according to claim 1, characterised in that it contains 10 to 80 wt.% of polymerisable compound, 20 to 90 wt.% of polymeric binder and 0.05 to 20 wt.%, relative to the non-volatile constituents of the mixture, of radiation-activatable polymerisation initiators.

11. Photopolymerisable recording material having a support and a photopolymerisable layer, characterised in that the photopolymerisable layer consists of a mixture according to claim 1.

12. Recording material according to claim 11, characterised in that it contains on the photopolymerisable layer a further, transparent layer having low oxygen permeability which is soluble in a developer liquid for the photopolymerisable layer.

## Revendications

1. Mélange photopolymérisable qui contient comme composants essentiels
a) un liant polymère
b) un composé polymérisable par voie radicalaire avec au moins un groupe polymérisable et
c) un colorant photoréductible
caractérisé en ce qu'il contient en outre
d) un dicyclopentadiényl-bis-2,4,6-trifluorophényltitane ou -zirconium.

2. Mélange selon la revendication 1, caractérisé en ce qu'il contient en plus
e) un composé trihalogénométhyle éliminable sous l'effet du rayonnement.

3. Mélange selon la revendication 1, caractérisé en ce qu'au moins l'un des restes cyclopentadiényles est substitué.

4. Mélange selon la revendication 1, caractérisé en ce que le composé polymérisable par voie radicalaire est un acrylate ou alcacrylate avec au moins un groupe photo-oxydable lors de l'irradiation en présence du colorant photoréductible.

5. Mélange selon la revendication 4, caractérisé en ce que le groupe photo-oxydable est un groupe amino, urée, thio ou énol.

6. Mélange selon la revendication 1, caractérisé en ce que le colorant photoréductible est un colorant xanthène, thiazine, pyronine, porphyrine ou acridine.

7. Mélange selon la revendication 2, caractérisé en ce que le composé trihalogénométhyle éliminable par rayonnement est une s-triazine, qui est substituée par au moins un groupe trihalogénométhyle et le cas échéant un autre groupe, ou est une aryltrihalogénométhylsulfone.

8. Mélange selon la revendication 1, caractérisé en ce qu'il contient en outre comme photoinitiateur un composé efficace acridine, phénazine ou quinoxaline.

9. Mélange selon la revendication 1, caractérisé en ce que le liant est insoluble dans l'eau et est soluble dans les solutions aqueuses alcalines.

10. Mélange selon la revendication 1, caractérisé en ce qu'il contient 10 à 80% en poids de composé polymérisable, 20 à 90% en poids de liant polymère et 0,05 à 20% en poids, par rapport aux composants non volatils du mélange, d'initiateurs de polymérisation activables par le rayonnement.

11. Matériau d'enregistrement photopolymérisable avec un support de couche et une couche photopolymérisable, caractérisé en ce que la couche photopolymérisable est constituée d'un mélange selon la revendication 1.

12. Matériau d'enregistrement selon la revendication 11, caractérisé en ce qu'il comprend sur la couche photopolymérisable une autre couche transparente peu perméable à l'oxygène, qui se dissout dans un liquide de développateur pour la couche photopolymérisable.
